# EUROPEAN PATENT APPLICATION

(11) **EP 1 816 231 A1**
(43) Date of publication of application: **08.08.2007**
(21) Application number: 05800431.8
(22) Date of filing: 01.11.2005
(51) Int. Cl.: C23C 14/12, C08J 7/12, C08L 101/00

(54) **FLUOROCARBON FILM AND PROCESS FOR PRODUCING THE SAME**

(30) Priority: 02.11.2004 JP 2004319296
(71) Applicant: Asahi Glass Company, Limited, Chiyoda-ku, Tokyo 100-8405 (JP)
(72) Inventor: TAMITSUJI, Chikaya c/o Asahi Glass Company, Ltd., Kanagawa 221-8755 (JP); HIGASHI, Seiji c/o Asahi Glass Company, Limited, Kanagawa 221-8755 (JP); TATEMATSU, Shin c/o Asahi Glass Company, Limited, Tokyo 100-8405 (JP); OKI, Satoshi c/o Asahi Glass Company, Limited, Kanagawa 221-8755 (JP)
(74) Representative: Müller-Boré & Partner Patentanwälte
(86) International application number: PCT/JP2005/020082
(87) International publication number: WO 2006/049153

(57) **Abstract**

To provide a process for producing a fluorocarbon film, which is capable of constantly forming a fluorocarbon film excellent in durability and functionality.

The process for producing a fluorocarbon film of the present invention is a process for producing a fluorocarbon film at least a part of which is chemically bonded to a substrate surface, and is **characterized by** conducting, in sequence, step (a) for applying plasma to a substrate surface in a continuous or pulse manner to form active points on the substrate surface and step (b) for applying plasma to the substrate surface in a continuous or pulse manner in the presence of a gas of a fluorocompound represented by the formula CₓF_{y} and/or CₓF_{y}O_{z} under such a condition that active species impinge on the substrate surface at a relatively lower collision energy than in step (a).

## Description

### TECHNICAL FIELD

The present invention relates to a process for producing a fluorocarbon film at least a part of which is chemically bonded to a substrate surface, a fluorocarbon film produced by such a process, and a fluorocarbon film provided with a substrate.

### BACKGROUND ART

A fluorocarbon such as polytetrafluoroethylene (PTFE) is excellent in the water and oil repellency, anti-fouling property, release property, weather resistance, low refractive index characteristic, low friction property, chemical resistance, etc., and it is used for various applications.

Further, with a view to reducing the costs, etc., it has been proposed to form a fluorocarbon film on the surface of a non-fluorinated substrate. As a method for forming a fluorocarbon film on a substrate surface, a direct fluorination method by means of a fluorine gas (Non-Patent Document 1), a plasma polymerization method (Patent Document 1), a Langmuir-Blodgett (LB) method (Patent Document 2), a vacuum vapor deposition method, a sputtering method, a surface treatment with a fluorinated silane coupling agent, or a fluoropolymer-coating, may, for example, be mentioned.

Among them, the direct fluorination method by means of a fluorine gas or the plasma polymerization method is, for example, preferred, since a thin film can be formed and at least a part of the fluorocarbon film can be chemically bonded to the substrate surface. Particularly preferred is the plasma polymerization method, wherein a high energy state of plasma is utilized, whereby a monomer (such as a non-vinyl monomer) which is usually difficult to polymerize, may be introduced, and the degree of freedom in designing the film is high, such being desirable.

In the plasma polymerization method, a fluorocarbon is grafted to a substrate surface, and theoretically, it should be possible to obtain a film which has high durability and which is excellent in a functionality such as water and oil repellency. However, in the plasma polymerization method, control of the film forming conditions is difficult, and it used to be difficult to constantly form a fluorocarbon film with high durability and high functionality.

It is considered that due to the utilization of the high energy state, a phenomenon is likely to occur such that the substrate receives a damage during the film formation, the structural regularity of the active species of the monomer is disturbed, whereby a fluorocarbon having low structural regularity tends to be formed, or the formed fluorocarbon is damaged.

Whereas, low energy plasma irradiation is not preferred, since the polymerization rate tends to be thereby substantially slow, and it tends to be difficult to chemically bond the fluorocarbon to the substrate surface.

Under the circumstances, the following methods, have, for example, been proposed to stabilize film formation.
(1) A method wherein plasma is applied by pulse irradiation to control the amount of CF₂ carbene to be formed in the plasma polymerization process (Patent Documents 3 and 4).
(2) A method wherein the supply ratio of a hydrocarbon monomer to a fluoromonomer is changed with time, so that at the initial stage of film formation, a hydrocarbon film having high adhesion to the substrate is formed and thereafter, a film having fluorine introduced gradually, is formed (Patent Document 5).

In the above prior art (1), a polytetrafluoroethylene (PTFE) film (not one formed on a substrate) wherein CF₂ groups are linearly chained, and CF groups are little, is obtained. However, the amount of CF₃ groups is substantially small (e.g. Fig. 3C of Patent Document 4).

Further, in the prior art (1), the amount of CF₂ carbene formed in the plasma polymerization process is controlled by the pulse irradiation of plasma.

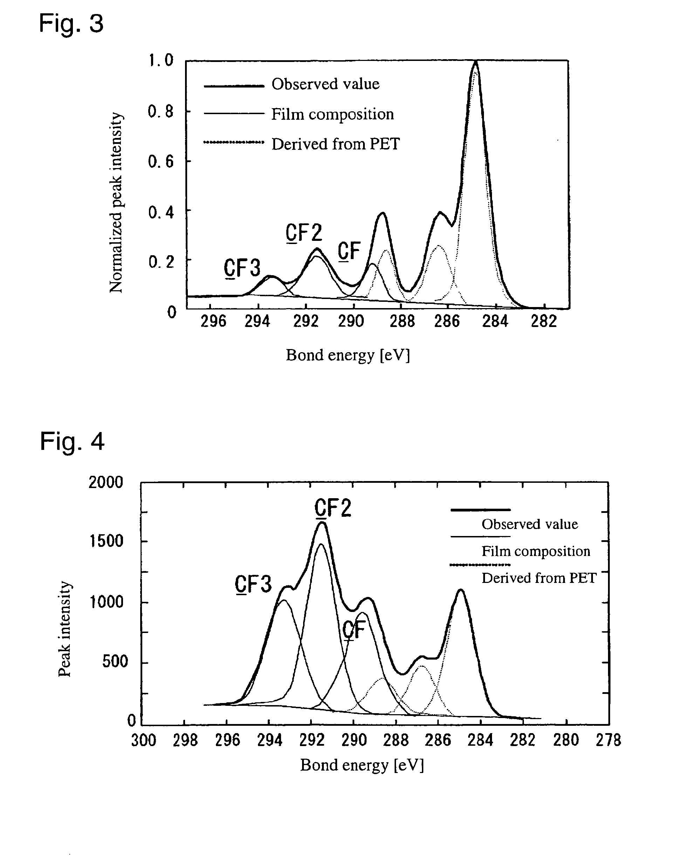

For example, Patent Document 4 discloses, in Claim 1, "A structure having a fluorocarbon polymer thin film ..... thereon, the polymer film having a fractional composition given as x% CF₂, (100-x) / 2% CF₃, (100-x) /2% CF, and substantially 0% C, where x is greater than about 80 and less than 100". Further, in Fig. 3B (EXAMPLE 1) in the same document, a fluorocarbon film is disclosed which has a composition comprising 65% of CF₂ groups, about 15% of CF₃ groups, and about 10% of CF groups (except for CF₂ groups, the values were read-out from the Fig. by the present inventors).

Namely, in the prior art (1), CF groups are increased at the same time as CF₃ groups, and such is entirely different from the technique of the present invention to increase CF₃ groups while decreasing CF groups.
Patent Document 1: JP-A-55-099932
Patent Document 2: JP-A-62-000572
Patent Document 3: US Patent 5,888,591
Patent Document 4: US Patent 6,156,435
Patent Document 5: JP-A-09-059318
Non-Patent Document 1: R.J. Lagow, J.L. Margrave, "Direct Fluorination: A "New" Approach to Fluorine Chemistry", Progress in Inorganic Chemistry, 26, 1979, p.161.

### DISCLOSURE OF THE INVENTION

### PROBLEMS TO BE SOLVED BY THE INVENTION

By the above prior art (1) and (2), it is still difficult to constantly form a fluorocarbon film having high durability and high functionality. Further, in the prior art (2), it is necessary to change the gas composition to be sequentially introduced, whereby the apparatus or process is extremely cumbersome.

The present invention has been made under the above circumstances, and it is an object of the present invention to provide a process for producing a fluorocarbon film, whereby a fluorocarbon film excellent in the durability and functionality (such as water and oil repellency) can be constantly formed by a relatively simple process, and the film may be made thin.

Further, another object is to provide a thin film-form fluorocarbon film excellent in the durability and functionality (such as water and oil repellency), and a fluorocarbon film provided with a substrate having such excellent properties.

### MEANS TO SOLVE THE PROBLEMS

The present inventors have conducted an extensive study to solve the above problems and have invented the following process for producing a fluorocarbon film.

The present invention provides a process for producing a fluorocarbon film, characterized by conducting, in sequence, step (a) for applying plasma to a substrate surface in a continuous or pulse manner to form active points on the substrate surface and step (b) for applying plasma to the substrate surface in a continuous or pulse manner in the presence of a gas of a fluorocompound represented by the formula CₓF_{y} and/or CₓF_{y}O_{z} (wherein each of x, y and z is a positive integer not including 0) under such a condition that active species impinge on the substrate surface at a relatively lower collision energy than in step (a).

In this specification, "plasma irradiation in a continuous manner" includes not only continuous irradiation at the same output but also a case where continuous irradiation is carried out when changing the output, such as increasing or decreasing the output.

In step (b), as a means to carry out plasma irradiation under such a condition that active species impinge on the substrate surface at a relatively lower collision energy than in step (a), it is preferred to change at least one condition, as between steps (a) and (b), among the average plasma output per unit time, the atmosphere pressure and the interelectrode distance.

In this specification, "plasma output" corresponds to an electric power (discharge power) per unit area applied to the electrodes. Further, "average plasma output per unit time" is defined, in the case of pulse irradiation, by a value obtained by dividing the output during irradiation by the time for one cycle of irradiation once/non-irradiation once. Accordingly, even with the same absolute output, if the continuous irradiation is switched to pulse irradiation, the output per unit time will decrease.

For example, when the plasma output is set to be 20 W/cm² and the duty ratio (the ratio of the irradiation time to the non-irradiation time in one cycle) is set to be 1:4, the output per unit time will be 4 W/cm².

Further, "interelectrode distance" means a distance between the lower electrode and the upper electrode opposingly disposed thereto (plasma discharge is carried out between these electrodes).

Step (a) is preferably carried out in the presence of at least one type of gas selected from the group consisting of hydrogen, helium, nitrogen, oxygen, fluorine, argon, carbon monoxide, carbon dioxide, nitrogen dioxide, steam and a gas of a fluorocompound represented by the formula CₓF_{y} and/or CₓF_{y}O_{z} (wherein each of x, y and z is a positive integer not including 0). It is particularly preferred to use the same gas in steps (a) and (b).

The fluorocarbon film of the present invention is characterized in that it is produced by the process for producing a fluorocarbon film according to the above-described present invention.

The present invention provides a fluorocarbon film at least a part of which is chemically bonded to a substrate surface and which contains at most 8 mol% of CF groups, from 20 to 90 mol% of CF₂ groups and from 10 to 80 mol% of CF₃ groups, based on the total amount of CF groups, CF₂ groups and CF₃ groups.

In this specification, mol% of CF groups, CF₂ groups and CF₃ groups is obtained by taking narrow spectra of the 1s orbit of carbon atoms of a fluorocarbon film by a X-ray photoelectron spectroscopic apparatus (ESCA, Model 5500, manufactured by PHI) and subjecting them to peak division into C, CF, CF₂ and CF₃.

The fluorocarbon film provided with a substrate of the present invention is characterized in that it comprises the above-mentioned fluorocarbon film formed on the substrate surface.

### EFFECTS OF THE INVENTION

According to the present invention, it is possible to provide a process for producing a fluorocarbon film, whereby a fluorocarbon film excellent in the durability and functionality (such as water and oil repellency) can be constantly formed by a relatively simple process, and the film may be made thin.

According to the present invention, it is possible to provide a thin film-form fluorocarbon film excellent in the durability and functionality (such as water and oil repellency), and a fluorocarbon film provided with a substrate having such excellent properties.

### BRIEF DESCRIPTION OF THE DRAWINGS

Fig. 1 is a view showing the apparatus used in Example 1.
Fig. 2 is a graph showing the ESCA spectrum in Example 1.
Fig. 3 is a graph showing the ESCA spectrum in Comparative Example 1.
Fig. 4 is a graph showing the ESCA spectrum in Comparative Example 2.
Fig. 5 is a view showing the apparatus used in Example 2, etc.
Fig. 6 is a graph showing the ESR spectrum in Example 3.

### MEANINGS OF SYMBOLS

- 1:: Chamber
- 2:: Upper electrode (φ 10 cm)
- 3:: Lower electrode (φ 10 cm)
- 4:: Heater
- 5:: High frequency power source (13.56 MHz)
- 6:: Earth
- 7:: Exhaust port leading to an exhaust equipment
- 8:: Pressure meter
- 9:: Flow meter
- 10:: Gas supply system
- 11:: Matching circuit
- 12:: Substrate

### BEST MODE FOR CARRYING OUT THE INVENTION

### Process for Producing a Fluorocarbon Film

The process for producing a fluorocarbon film of the present invention is a process for producing a fluorocarbon film at least a part of which is chemically bonded to a substrate surface, which comprises, in sequence, step (a) for applying plasma to a substrate surface in a continuous or pulse manner to form active points on the substrate surface and step (b) for applying plasma to the substrate surface in a continuous or pulse manner in the presence of a gas of a fluorocompound represented by the formula CₓF_{y} and/or CₓF_{y}O_{z} (wherein each of x, y and z is a positive integer not including 0) under such a condition that active species impinge on the substrate surface at a relatively lower collision energy than in step (a).

Namely, in the present invention, in step (a), plasma irradiation is carried out under a relatively severe condition to form active points (radicals) to be starting points for film growth, on the substrate surface, and then, in step (b), plasma irradiation is carried out under a relatively mild condition in the presence of a gas of a fluorocompound as a monomer, to let the film grow.

In the present invention,
(1) In step (a), active points are formed on the substrate surface, and a polymer chain will undergo graft growth from the active points formed on the substrate surface as the starting points, whereby a fluorocarbon at least a part of which is chemically bonded to the substrate surface, can be formed. It is considered that as a result, a fluorocarbon film excellent in the durability will be formed.
(2) The film growth of the fluorocarbon film proceeds mainly in step (b) under a relatively mild plasma condition. Accordingly, it is considered that a damage of the substrate during the film formation can be suppressed, and the structural regularity of the active species of the monomer is free from being disturbed by a high energy plasma environment, whereby a film having a high structural regularity can be grown, and a damage to the formed fluorocarbon can also be prevented. Further, it is considered that such effects are combined, so that a fluorocarbon having a high structural regularity can be constantly grown, and as a result, a fluorocarbon film excellent in the functionality (such as water and oil repellency) can be constantly formed.

Thus, according to the process of the present invention, the above effects (1) and (2) are combined, so that a fluorocarbon film excellent in the durability and functionality (such as water and oil repellency) can be constantly formed.

### Substrate

The substrate is not particularly limited so long as the active points can be formed by plasma irradiation.

The material for the substrate may, for example, be a polyolefin such as polyethylene or polypropylene; a non-fluorinated organic polymer such a polyvinyl chloride, polycarbonate, polyester, polyether, polyamide, polyimide, polyvinyl alcohol, polyurethane or polycellulose; a metal such as copper, iron, stainless steel, aluminum, nickel or an alloy thereof; a metal oxide such as silicon dioxide (such as glass) or aluminum oxide; or a composite material thereof. Particularly preferred is a non-fluorinated organic polymer. Among them, a polyester is more preferred.

The substrate may be in any form such as a sheet form, a film form, a flat plate form, a hollow filament form, a cylindrical form, a container form, a rod form, a spherical form, a block form or a powder form. A sheet form, a film form or a flat plate form is preferred. Gas

As mentioned above, step (a) is a step for forming active points (radicals) which will be starting points for film growth on the substrate surface. The film growth proceeds mainly in step (b).

Accordingly, in step (a), it is simply required that a sufficient amount of active points are formed on the substrate surface. Accordingly, the gas to be used in step (a) may be any optional gas so long as it is capable of forming active species in the plasma. Namely, in step (a), it is not essential to employ a gas of a fluorocompound as the monomer.

Whereas, in step (b), it is essential to employ a gas of a fluorocompound represented by the formula CₓF_{y} and/or CₓF_{y}O_{z} (wherein each of x, y and z is a positive integer not including 0).

In step (a), a gas of a non-fluorinated compound such as hydrogen, helium, nitrogen, oxygen, fluorine, argon, carbon monoxide, carbon dioxide, nitrogen dioxide or steam may be employed. Otherwise, it is preferred to carry out the step in the presence of a gas of a fluorocompound such as a gas represented by the formula CₓF_{y} and/or CₓF_{y}O_{z} (wherein each of x, y and z is a positive integer not including 0). As the gas, one type or a mixture of two or more types may be employed.

The gas to be used in step (a) is preferably a gas of a non-fluorinated compound from the viewpoint of production cost, and it is preferably the same gas as in step (b) when the production efficiency or the convenience of the apparatus are taken into consideration.

The gas to be used in step (b) is not particularly limited so long as it is a gas of a fluorocompound represented by the formula CₓFy and/or CₓFyO_{z} (wherein each of x, y and z is a positive integer not including 0). The gas to be used in step (b) is preferably one having a low global warming coefficient and being capable of readily forming CF₂ carbene required for the film growth.

Such a gas of a fluorocompound may, for example, be tetrafluoroethylene, hexafluoropropylene, hexafluoropropylene oxide (HFPO), perfluorobenzene or a compound represented by the following formulae. These gases may be used alone or in combination as a mixture of two or more of them. Further, such a gas may be used for the reaction as diluted with a gas of a non-fluorinated compound.

PPVE ... CF₂=CF-O-CF₂-CF₂-CF₃

PMVE ... CF₂=CF-O-CF₃

AVE...CF₂=CF-O-CF₂-CF=CF₂

BVE...CF₂=CF-O-CF₂-CF₂-CF=CF₂

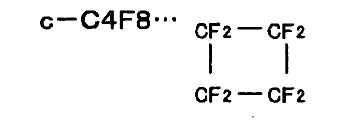

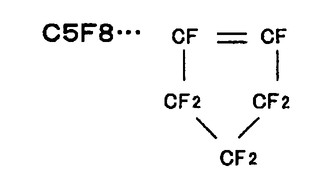

### Plasma Irradiation Conditions

In step (a), plasma irradiation is carried out under such a condition that a sufficient amount of active points can be formed on the substrate surface. In step (b), plasma irradiation is carried out under such a condition that active species impinge on the substrate surface at a collision energy relatively lower than in step (a). In each step, the plasma is applied in a continuous or pulse manner.

The present inventors have found that it is possible to change the collision energy of the active species on the substrate surface by changing one or more of conditions such as the average plasma output per unit time, the atmosphere pressure and the interelectrode distance. Specifically, it is possible to lower the collision energy of the active species on the substrate surface relatively by e.g. lowering the average plasma output per unit time, by increasing the atmosphere pressure or increasing the interelectrode distance.

It is considered that as the average plasma output per unit time is higher, the density in number of active species to be formed in the plasma increases, whereby the collision energy on the substrate surface becomes large. Further, the present inventors have found that in order to change the collision energy of active species on the substrate surface, "the average plasma output per unit time" is more effective than "the peak output of the plasma". Accordingly, even with the same peak output, if the continuous irradiation is switched to pulse irradiation, the average output per unit time will decrease, whereby the collision energy of active species on the substrate surface can be lowered.

It is considered that as the atmosphere pressure becomes low, the electron temperature becomes high, whereby the collision energy of active species on the substrate surface becomes large.

It is considered that as the interelectrode distance becomes small, the energy per unit volume in the plasma field becomes large, and the active species in a high energy state relatively increases, whereby the collision energy of the active species on the substrate surface becomes large.

The change of the condition such as the average output per unit time, the atmosphere pressure or the interelectrode distance after completion of step (a) may be carried out instantaneously, or the condition may be continuously or stepwisely increased or lowered.

For example, in a case where continuous irradiation is carried out in steps (a) and (b), and the plasma output is substantially changed, in order to generate glow plasma constantly, it is preferred to lower the plasma output continuously or stepwisely. In such a case, "the average plasma output per unit time" relatively decreases during this transfer process, which is therefore contained in step (b).

In adopting either continuous irradiation or pulse irradiation, it is preferred to carry out the plasma irradiation under such a condition that glow plasma is generated while no arc plasma is generated, whereby a uniform film can be formed.

The plasma generator is not particularly limited so long as it is capable of generating glow plasma, and a DC discharge type or an AC discharge type may be employed. In a case where an AC discharge type is to be employed, as the discharge power source, it is preferred to employ a high frequency power source of 13.56 MHz which is industrially commonly used, from the viewpoint of the cost for the apparatus. The AC discharge type includes, for example, a capacitively coupled type and an inductively coupled type.

The gas supply type may, for example, be a nozzle type wherein a nozzle is disposed obliquely to the substrate surface, so that the gas is supplied from one direction, or a shower head type wherein a shower head having a plurality of gas ejection holes is disposed to face against the substrate surface, so that the gas is supplied from the plurality of ejection holes substantially perpendicularly. It is particularly preferred to employ the latter shower head type from the viewpoint of the uniform supply of the gas and the consequent improvement in the utilization efficiency of the gas, and an improvement of the film uniformity.

Now, a case will be described in which as between steps (a) and (b), only one condition among the average plasma output per unit time, the atmosphere pressure and the interelectrode distance, is changed.

### THE CHANGE OF THE AVERAGE PLASMA OUTPUT PER UNIT TIME

A case will be described wherein "the average plasma output per unit time" is changed so that in step (b), the active species are impinged on the substrate surface at a collision energy relatively lower than in step (a) thereby to carry out film growth.

In step (a), conditions such as the type of substrate, the type of the gas, the atmosphere pressure, the plasma output, the type of the apparatus, the type of the discharge power source and the interelectrode distance are determined so as to activate the substrate surface to form a sufficient amount of active points and to present no damage other than the surface of the substrate. In step (b), plasma irradiation is carried out by relatively lowering the average output per unit time than in step (a).

If the average plasma output (W_{H}) per unit time in step (a) is too small, active species in an amount to sufficiently activate the substrate surface will not be formed in the plasma, whereby active points will not be formed in a sufficient amount on the substrate surface. Consequently, the amount of a fluorocarbon chemically bonded to the substrate surface tends to be inadequate, and the durability of the fluorocarbon film tends to be inadequate. If the average plasma output (W_{L}) per unit time in step (b) is too high, the structural regularity of the active species of the monomer tends to be disturbed, whereby it tends to be difficult to form a fluorocarbon having a high structural regularity. Accordingly, the conditions will be decided taking these points into consideration.

For example, in a case where a substrate having a relatively low heat resistance such as a resin is treated under an atmosphere pressure of from 45 to 55 Pa with an interelectrode distance of from 80 to 100 mm by using hexafluoropropylene oxide as the monomer in step (b) to form CF₂ carbene relatively easily and by using a nozzle type as the gas supply type, a high frequency power source of 13.56 MHz as the discharge power source and a discharge apparatus employing capacitively coupled parallel flat plates, the following conditions are preferred, since a sufficient amount of active points can be formed on the substrate surface, and a fluorocarbon having a high structural regularity at least a part of which is chemically bonded to the substrate, can be constantly obtained.

Namely, the average plasma output (W_{H}) per unit time in step (a) is preferably from about 0.1 to 20 W/cm², particularly preferably from about 1 to 10 W/cm². The average plasma output (W_{L}) per unit time in step (b) is preferably a value relatively lower than in step (a) within a range of from about 0.01 to 5 W/cm², particularly 0.1 to 2.5 W/cm². The ratio in the plasma output per unit time between steps (a) and (b) (W_{H/}W_{L}) is preferably at least 1.2, particularly preferably from 2 to 50.

### ATMOSPHERE PRESSURE

A case will be described wherein "the atmosphere pressure" is changed so that in step (b), the active species are permitted to impinge on the substrate surface at a collision energy relatively lower than in step (a) to carry out film growth.

The atmosphere pressure is preferably set within a range wherein glow plasma will constantly be generated (no arc plasma will be generated).

If the atmosphere pressure is too low, the absolute amount of the gas to be converted to plasma tends to be too small, whereby it tends to be difficult to generate glow plasma constantly. If it is too high, the glow discharge region tends to be narrow, and transfer to an arc discharge region is likely to occur. Accordingly, the atmosphere pressure in steps (a) and (b) is preferably changed within a range of from 10 Pa to atmospheric pressure.

For example, in a case where a substrate having relatively low heat resistance such as a resin is treated at an average plasma output per unit time of from 3.6 to 4.0 W/cm² with an interelectrode distance of from 70 to 80 mm by using hexafluoropropylene oxide as the monomer in step (b) to form CF₂ carbene relatively easily and using a shower head type as the gas supply type, a high frequency power source of 13.56 MHz as the discharge power source and a discharge apparatus employing capacitively coupled parallel flat plates, the atmosphere pressure in step (a) is preferably from about 10 to 50 Pa, particularly preferably from about 20 to 40 Pa. Further, the atmosphere pressure in step (b) is preferably within a range of from about 30 to 100 Pa, particularly from about 50 to 80 Pa and is a value relatively higher than in step (a).

### INTERELECTRODE DISTANCE

A case will be described wherein "the interelectrode distance" is changed so that in step (b), the active species are permitted to impinge on the substrate surface with a collision energy relatively lower than in step (a) to carry out film growth.

The interelectrode distance is preferably set within a range wherein glow plasma will constantly be generated (no arc plasma will be generated).

Specifically, the interelectrode distance in step (a) or (b) is preferably adjusted within a range of from 1 to 300 mm, particularly preferably from 3 to 100 mm. For example, in a case where a substrate having a relatively low heat resistance such as a resin is treated under an atmosphere pressure of from 45 to 55 Pa at an average plasma output per unit time of from 3.6 to 4.0 W/cm² by using hexafluoropropylene oxide as the monomer in step (b) to form CF₂ carbene relatively easily and using a shower head type as the gas supply type, a high frequency power source of 13.56 MHz as the discharge power source and a discharge apparatus employing capacitively coupled parallel flat plates, the interelectrode distance in step (a) is preferably from 20 to 60 mm, particularly preferably from 35 to 55 mm. Further, the interelectrode distance in step (b) is preferably from 50 to 100 mm, particularly preferably from 70 to 80 mm and is a value relatively larger than in step (a).

As described above, according to the process for producing a fluorocarbon film of the present invention, in step (a), plasma irradiation is carried out under a relatively severe condition to form active points which will be starting points for film growth, on the substrate surface, and then, in step (b), plasma irradiation is carried out under a relatively mild condition in the presence of a gas for a fluorocompound as a monomer to carry out film growth, whereby a fluorocarbon film excellent in the durability and functionality (such as water and oil repellency, anti-fouling property, release property, weather resistance, low refractive index characteristic, low friction property and chemical resistance) can be constantly formed.

Yet, in the process for producing a fluorocarbon film of the present invention, it is simply required to change the plasma irradiation condition such as the average plasma output per unit time, the atmosphere pressure or the interelectrode distance, as between steps (a) and (b). Therefore, as is different from the prior art (2) mentioned in "BACKGROUND ART" wherein it is required to change the gas composition sequentially introduced, the process for producing a fluorocarbon film of the present invention is excellent in the continuous productivity and is far simple in the process.

Further, the fluorocarbon film of the present invention is not limited in making the film thin. Namely, it is possible to form a shortest chain fluorocarbon film (theoretically, a film thickness of about 0.3 nm) having a monomolecular layer of CF₃ groups simply bonded to the substrate.

The thickness of the fluorocarbon film is not particularly limited. However, in consideration of the merit in making the film thin (such as reduction of the costs) or the stability in forming the film (which leads to the durability or functionality) by the present invention, the thickness is preferably at most 10 µm, more preferably at most 1 µm, further preferably at most 0.5 µm. The film thickness is most preferably within a range of from 0.4 to 100 nm. Here, with a commercially available one having a fluororesin laminated on another substrate, the film thickness is usually more than 10 µm.

### FLUOROCARBON FILM

The fluorocarbon film of the present invention is characterized in that it is one produced by the above-described process for producing a fluorocarbon film of the present invention.

According to the process for producing a fluorocarbon film of the present invention, a fluorocarbon film may be formed which has a structural regularity not heretofore attained.

The fluorocarbon of the present invention is not substantially branched, and a linear fluorocarbon is formed in a high proportion.

Further, since there is no limitation in making the film thin, a fluorocarbon having a relatively short chain with from about 2 to 8 carbon atoms may be constantly formed. If it is assumed that a linear fluorocarbon having a relatively short chain with from about 2 to 8 carbon atoms is present in a perpendicular direction to the substrate surface, the film thickness at that time will be from about 0.4 to 2 nm.

The above phenomenon means that among CF groups, CF₂ groups and CF₃ groups, it is possible to minimize the molar amount of CF groups located at branching points and to increase the molar amount of CF₃ groups located at terminals. Namely, when a fluorocarbon of the same mass is to be formed, according to the present invention, more fluorine atoms may be introduced, and the effects by introduction of fluorine atoms (water and oil repellency, anti-fouling property, release property, weather resistance, low refractive index characteristic, low friction property, chemical resistance, etc.) can be obtained at a higher level.

Specifically, according to the present invention, it is possible to provide a fluorocarbon film at least a part of which is chemically bonded to a substrate surface and which contains at most 8 mol% of CF group, from 20 to 90 mol% of CF₂ group and from 10 to 80 mol% of CF₃ group, based on the total amount of CF group, CF₂ group and CF₃ group.

According to the present invention, it is possible to bring CF group to at most 5 mol% or even to 0%, while CF₃ group is maintained at a high level of from 10 to 80 mol%. The amount of CF₃ group is preferably from 13 to 60 mol%, more preferably from 15 to 50 mol%.

The relation between the amount of CF₃ group and the amount of CF group is preferably (amount of CF₃ group)>(amount of CF group)×2.

Here, the more the amount of CF₃ group, the higher the effects by introduction of fluorine atoms. However, the more the amount of CF₃ group, the shorter the chain length, i.e. the thinner the film thickness. If the film thickness is too thin, it tends to be difficult to form a fluorocarbon over the entire substrate surface, and film defects are likely to result. Therefore, the amount of CF₃ group is preferably at most 80 mol%.

As described in the foregoing, the fluorocarbon film of the present invention can be made to be a thin film having a structural regularity of a high level not attained heretofore and is excellent in the durability and functionality (water and oil repellency, anti-fouling property, release property, weather resistance, low refractive index characteristic, low friction property, chemical resistance, etc.).

### FLUOROCARBON FILM PROVIDED WITH A SUBSTRATE

The fluorocarbon film provided with a substrate of the present invention is characterized in that it is one having the above-described fluorocarbon film of the present invention formed on a substrate surface.

The fluorocarbon film provided with a substrate of the present invention is one having the fluorocarbon film of the present invention and thus has the same effects as the fluorocarbon film of the present invention.

### EXAMPLES

Now, the present invention will be described with reference to Examples, but it should be understood that the present invention is by no means restricted by the following Examples. Here, for convenience sake, the process of the present invention by plasma irradiation in a plurality of steps will be referred to as "MCW process", the process of the present invention which includes a step of carrying out pulse plasma irradiation will be referred to as "MCW-pulse process", and a comparative process by continuous plasma irradiation in one step will be referred to as "CW process", and a comparative process by pulse plasma irradiation in one step will be referred to as "pulse process".

### EVALUATION ITEMS AND EVALUATION METHODS

### FILM COMPOSITION

The film composition of a formed fluorocarbon film i.e. mol% of CF group, CF₂ group and CF₃ group was obtained by taking a narrow spectrum of the 1s orbit of carbon atoms of the fluorocarbon film by an X-ray photoelectron spectroscopic apparatus (ESCA, Model 5500 manufactured by PHI) and subjecting it to peak division into C, CF, CF₂ and CF₃.

### CONTACT ANGLE (CA)

For evaluation of the water repellency, the contact angle of the formed fluorocarbon film against water was measured by a contact angle measuring apparatus (CA-X150, manufactured by Kyowa Interface Science Co., LTD.).

### DURABILITY

For evaluation of the durability of a wiping test was carried out wherein the surface of a formed fluorocarbon film was rubbed with Kim Wipe (tradename) linearly overlaid while manually pressed under 1N. After rubbing 50 times, letters or drawings were drawn on the film surface with an alcoholic ink (WBMAR-M, manufactured by PILOT corporation: water-based), and they were wiped off with Kim Wipe for one reciprocation, whereby the wiping efficiency was functionally evaluated by the following standards. Here, the wiping efficiency being good means that the water repellency of the fluorocarbon film is good, such efficiency being maintained even after the wiping test means that the durability of the film is good.

### EVALUATION STANDARDS

○: easily and satisfactorily wiped off
×: wiping off was difficult or impossible (the same level as the substrate)

### EXAMPLE 1

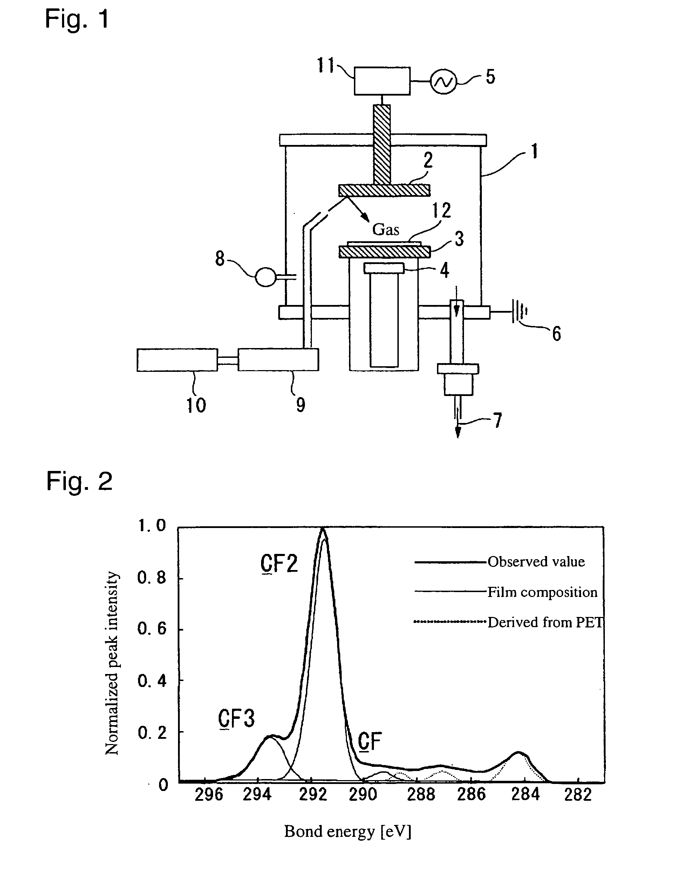

A fluorocarbon film was formed by using a nozzle type as the gas supply type, a high frequency power source of 13.56 MHz as the discharge power source and capacitively coupled parallel flat plates. Fig. 1 shows a schematic construction view of this discharge apparatus.

On a lower electrode 3, a polyethylene terephthalate (PET) film (substrate 12) (film thickness: 50 µm) was placed, and the gas in a chamber 1 was evacuated from an exhaust port 7 under reduced pressure until the pressure became not more than 1 Pa. While evacuating under reduced pressure, high purity nitrogen gas was supplied at 110 sccm to replace the interior of the chamber 1 with nitrogen gas. Thereafter, 62 sccm of hexafluoropropylene oxide (HFPO) gas and 5 sccm of high purity nitrogen gas were supplied to bring the atmosphere pressure to be 50 Pa. After the pressure was stabilized, the distance between the upper electrode 2 and the lower electrode 3 i.e. the interelectrode distance was adjusted to be 100 mm.

In this state, 2.5 W/cm² (W_{H}) of a high frequency power of 13.56 MHz was applied to the electrodes to generate continuous plasma and maintained for two minutes (step (a)). Thereafter, the high frequency power was continuously reduced at a rate of 0.30 W/cm² per minute to a level of 0.13 W/cm² (step (b1)). Further, continuous plasma with a power of 0.13 W/cm² (W_{L}) was continuously applied for 20 minutes (step (b2)) to complete the film formation (MCW method).

The main production conditions are shown in Table 1.

### COMPARATIVE EXAMPLE 1

Film forming was carried out in the same manner as in Example 1 except that as shown in Table 1, after adjusting the interelectrode distance to be 100 mm, steps (a) and (b1) were not carried out, and 0.13 W/cm² of a high frequency power of 13.56 MHz was applied to the electrodes to generate continuous plasma and maintained for 20 minutes (CW method).

### COMPARATIVE EXAMPLE 2

Film forming was carried out in the same manner as in Example 1 except that as shown in Table 1, after adjusting the interelectrode distance to be 40 mm, steps (a) and (b1) were not carried out, and 1.3 W/cm² of a high frequency power of 13.56 MHz was applied to the electrodes to generate pulse plasma with a frequency of 1 Hz at a duty ratio = 1:9 (100 msec-on, 900 msec-off), (average plasma output per unit time was 0.13 W/cm²), whereby treatment was carried out for 360 minutes (pulse method). In the Table, (p) represents pulse irradiation.

### RESULTS OF EXAMPLE 1 AND COMPARATIVE EXAMPLES 1 AND 2

The narrow spectra of the 1s orbits of carbon atoms by ESCA in Example 1 and Comparative Examples 1 and 2 are shown in Figs. 2 to 4. Further, the film compositions measured from the obtained spectra are also shown in Table 1 (the unit is "mol%"). Further, in these Examples, PET is used as the substrate, and the C=O peak overlaps the peak of the CF group. Therefore, the ESCA measurement of PET alone was carried out separately, and its peak is deducted from the spectrum of the observed value, followed by peak resolution to obtain the molar amount of each group.

In Figs. 2 to 4, the wide line is the spectrum of the observed value; the dotted line is the spectrum derived from PET; and the narrow line is a spectrum showing the film composition after the peak resolution.

As shown in the Table, in Example 1, CF group was 6.7%, and the CF₃ group was 15.4%, and a fluorocarbon film rich in the CF₃ group with a smaller molar amount of CF group, was obtained. The depth analysis by ESCA was carried out, whereby at a depth of 2 nm, only the peak of PET of the substrate appeared, whereby the film thickness was found to be at most 2 nm.

Whereas, in Comparative Examples 1 and 2, the amount of CF₃ group was large, and correspondingly, the amount of CF group was also large, and the contained fluorocarbon films had many branches and had a low structural regularity.

Further, the results of evaluation of the contact angle and durability of the film obtained in each Example are shown in Table 1.

The fluorocarbon film in Example 1 had a large contact angle of 120° and good water-repellency. Whereas, a commercially available PTFE film has a contact angle of from about 110 to 115°, and it is evident that the fluorocarbon film in Example 1 has a functionality higher than the commercially available PTFE film.

Further, the wiping efficiency of a white board marker after 50 times of the wiping test was also good, and the durability of the film was also good. Such good results are considered to be attributable to the fact that at least a part of the obtained fluorocarbon film is chemically bonded to the substrate surface. This is considered to be supported from the evaluation of the active points (radicals) on the substrate surface in the test example given hereinafter.

Whereas, the fluorocarbon films in Comparative Examples 1 and 2 had small contact angles and inferior functionality as compared with Example 1. Further, the film fell off after 50 times of the wiping test, and the film was not chemically bonded to the substrate, and the durability was poor.

**TABLE 1**

| | Gas (sccm) | Substrate | Pressure (Pa) | Inter-electrode distance (mm) | Steps | | | Film composition | | | CA (°) | Durability |
|---|---|---|---|---|---|---|---|---|---|---|---|---|
| | | | | | (a) | (b1) | (b2) | CF | CF₂ | CF₃ | | |
| Ex.1 | HFPO: 62 N₂ : 10 | PET | 50 | 100 | 2.5 W/cm² 2 min | 0.30 W/ (cm²·min) 8 min | 0.13 W/cm² 20 min | 6.7 % | 77.9 % | 15.4 % | 120 | ○ |
| Comp. Ex. 1 | HFPO: 62 10 N₂: 10 | PET | 50 | 100 | - | - | 0.13 W/cm² 20 min | 30.9 % | 50.1 % | 19.1 % | 105 | × |
| Comp. Ex. 2 | HFPO: 3 N₂ : 270 | PET | 100 | 40 | - | - | 0.13 W/cm² (p) 1 Hz on:off= 1:9 360 min | 39.7 % | 41.8 % | 28.5 % | 106 | × |

### EXAMPLES 2 AND 3 AND COMPARATIVE EXAMPLE 3

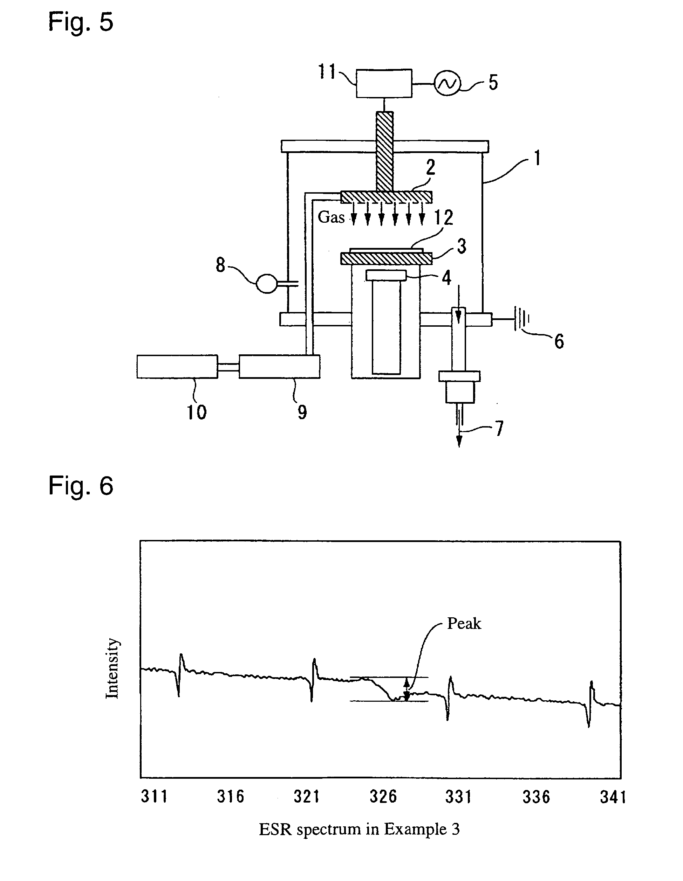

Film forming was carried out in the same manner as in Example 1 except that using a discharge apparatus as shown in Fig. 5, the conditions were changed as shown in Table 2. Fig. 5 shows a schematic construction view of this discharge apparatus. The apparatus in Fig. 5 is the same as the apparatus in Fig. 1 except that the gas supply type was changed to a shower head type (gas ejection holes: 100 holes), and the same components as in the apparatus in Fig. 1 are identified by the same symbols, and their detailed description will be omitted.

As shown in Table 2, in Examples 2 and 3, there was no step corresponding to step (b1) in Example 1, and step (a) was followed immediately by step (b). Further, the plasma output in steps (a) and (b) was the same, and instead, the gas supply amount was changed to let the atmosphere pressure change from 30 Pa to 70 Pa, so that in step (b), the active species were permitted to impinge on the substrate surface with a collision energy relatively lower than in step (a) to carry out the film forming.

Further, in Example 2, the same gas (HFPO) was used in steps (a) and (b), while in Example 3, argon (Ar) was used in step (a), and HFPO was used in step (b). On the other hand, in Comparative Example 3, no step (a) was carried out.

### EVALUATION OF EXAMPLES 2 AND 3 AND COMPARATIVE EXAMPLE 3

The evaluation results are shown in Table 2. It was confirmed that also by increasing the atmosphere pressure while maintaining the same plasma output, the same effects as lowering the plasma output could be obtained. Further, it was confirmed that in step (a), it is not necessary to use a gas of a fluorocompound as a monomer.

**TABLE 2**

| | Gas | | Substrate | Inter-electrode distance (mm) | Step (a) | | Step (b) | | CA (°) | Durability |
|---|---|---|---|---|---|---|---|---|---|---|
| | Type | (sccm) | | | Pressure (Pa) | Power, Time | Pressure (Pa) | Power, Time | | |
| Ex.2 | HFPO | 22 → 130 | PET | 78 | 30 | 3.8 W/cm² 1 min | 70 | 3.8 W/cm² 2 min | 116 | ○ |
| Ex.3 | Ar → HFPO | 22 → 130 | PET | 78 | 30 | 3.8 W/cm² 1 min | 70 | 3.8 W/cm² 2 min | 114 | ○ |
| Comp. Ex.3 | HFPO | 130 | PET | 78 | - | - | 70 | 3.8 W/cm² 2 min | 115 | × |

### EXAMPLE 4 AND COMPARATIVE EXAMPLE 4

Film forming was carried out in the same manner as in Example 2 except that the conditions were changed as shown in Table 3. In Example 4, the plasma output in steps (a) and (b) was the same, the gas supply amount was constant at 62 sccm to adjust the atmosphere pressure to be constant at 50 Pa, and instead, the interelectrode distance was changed from 40 to 78 mm, so that in step (b), the active species were permitted to impinge on the substrate surface with a collision energy relatively lower than in step (a), to carry out the film forming.

In Comparative Example 4, film forming was carried out by a CW method in the same manner as in Example 4 except that no step (a) was carried out.

### EVALUATION OF EXAMPLE 4 AND COMPARATIVE EXAMPLE 4

The evaluation results are shown in Table 3. It was confirmed that also by increasing the interelectrode distance while maintaining the same plasma output, the same effect as lowering the plasma output could be obtained.

**TABLE 3**

| | Gas | | Substrate | Pressure (Pa) | Step (a) | | Step (b) | | CA (°) | Durability |
|---|---|---|---|---|---|---|---|---|---|---|
| | Type | (sccm) | | | Inter-electrode distance (mm) | Power, Time | Inter-electrode distance (mm) | Power, Time | | |
| Ex.4 | HFPO | 62 | PET | 50 | 40 | 2.5 W/cm² 1 min | 78 | 2.5 W/cm² 2 min | 108 | ○ |
| Comp. Ex.4 | HFPO | 62 | PET | 50 | - | - | 78 | 2.5 W/cm² 2 min | 111 | × |

### EXAMPLE 5 AND COMPARATIVE EXAMPLE 5

Film forming was carried out in the same manner as in Example 2 except that the number of gas ejection holes of the shower head was changed to 5, and the conditions were changed as shown in Table 4. In Example 5, in step (b), a high frequency power of 3.8 W/cm² was applied to the electrodes to generate pulse plasma with a frequency of 2 Hz at a duty ratio = 1:4 (100 msec-on, 400 msec-off) (average plasma output per unit time: 0.76 W/cm²), whereby treatment was carried out for two minutes to carry out the film forming (MCW-pulse method).

In Comparative Example 5, film forming was carried out by a pulse method in the same manner as in Example 5 except that no step (a) was carried out.

### EVALUATION OF EXAMPLE 5 AND COMPARATIVE EXAMPLE 5

The evaluation results are shown in Table 4.

It was confirmed that the same effect can be obtained even when the continuous irradiation was switched to pulse irradiation while maintaining the same plasma output.

**TABLE 4**

| | Gas | | Substrate | Inter-electrode distance (mm) | Step (a) | | Step (b) | | CA (°) | Durability |
|---|---|---|---|---|---|---|---|---|---|---|
| | Type | (sccm) | | | Pressure (Pa) | Power, Time | Pressure (Pa) | Power, Time | | |
| Ex.5 | HFPO | 22 → 130 | PET | 50 | 30 | 3.8 W/cm² 1 min | 70 | 0.76 W/m² (p) 2 Hz on:off= 1:4 2 min | 108 | ○ |
| Comp. Ex.5 | HFPO | 130 | PET | 50 | - | - | 70 | 0.76 W/cm² (p) 2 Hz on:off= 1:4 2 min | 102 | × |

### EXAMPLE 6 AND COMPARATIVE EXAMPLE 6

Film forming was carried out in the same manner as in Example 2 except that the conditions were changed as shown in Table 5. In Example 6, the supply gas was a mixed gas of HFP/Ar, and the atmosphere pressure was 10,000 Pa throughout the entire process. Here, HFP represents hexafluoropropylene.

Further, in step (b), a high frequency power of 1.3 W/cm² was applied to the electrodes to generate pulse plasma with a frequency of 1 Hz at a duty ratio = 1:9 (100 msec-on, 900 msec-off) (average plasma output per unit time: 0.13 W/cm²), whereby treatment was carried out for 90 seconds to carry out the film forming (MCW-pulse method).

In Comparative Example 6, film forming was carried out by the pulse method in the same manner as in Example 6 except that no step (a) was carried out.

### EVALUATION OF EXAMPLE 6 AND COMPARATIVE EXAMPLE 6

The evaluation results are shown in Table 5.

It was made evident that according to the present invention, a film excellent in the durability and functionality can be obtained even when the vacuum degree is made low at a level of the atmosphere pressure being 10,000 Pa. The fact that a film with such a high performance can be obtained even at a low vacuum degree, makes it possible to simplify the apparatus or the process, such being desirable.

**TABLE 5**

| | Gas | | Substrate | Inter-electrode distance (mm) | Step (a) | | Step (b) | | CA (°) | Durability |
|---|---|---|---|---|---|---|---|---|---|---|
| | Type | (sccm) | | | Pressure (pa) | Power, Time | Pressure (Pa) | Power, Time | | |
| Ex.6 | HFP: 2 Ar: 1,680 | | PET | 3 | 10,000 | 1.3 W/cm² 30 sec | 10,000 | 0.13 W/cm² (P) 1 Hz on:off= 1:9 90 sec | 110 | ○ |
| HFP: Comp. 2 Ex.6 Ar: 1,680 | | | PET | 3 | - | - | 10,000 | 0.13 W / cm² (p) 1 Hz on:off= 1:9 90 sec | 105 | × |

### TEST EXAMPLE

After step (a), the following test was carried out to confirm that active points are formed on the substrate surface.

After carrying out step (a) in Example 3, plasma irradiation was stopped and nitrogen was introduced into the chamber to the atmospheric pressure. Then, while nitrogen was supplied, the chamber was opened, and the sample was put into a test tube in the chamber, and the test tube was closed in the nitrogen atmosphere. Immediately thereafter, the test tube was cooled with liquid nitrogen, and the amount of remaining radicals was measured by means of ESR measurement (using JES-TE300, manufactured by JEOL DATUM). The mass of the sample was 6.87 mg.

The ESR spectrum is shown in Fig. 6. The peak intensity obtained by deducting the blank peak intensity of 8,317 was 4,126, and the peak intensity per unit mass was 601 mg⁻¹. From this result, it was confirmed that active points (radicals) were formed on the substrate surface after step (a).

### INDUSTRIAL APPLICABILITY

The fluorocarbon film presented by the present invention is excellent in the durability and at the same time is excellent also in the functionality such as water and oil repellency, anti-fouling property, release property, weather resistance, low refractive index characteristic, low friction property and chemical resistance, and thus, it is preferably used as e.g. various high performance films such as release films.

The entire disclosure of Japanese Patent Application No. 2004-319296 filed on November 2, 2004 including specification, claims, drawings and summary is incorporated herein by reference in its entirety.

## Claims

1. A process for producing a fluorocarbon film, **characterized by** conducting, in sequence, step (a) for applying plasma to a substrate surface in a continuous or pulse manner to form active points on the substrate surface and step (b) for applying plasma to the substrate surface in a continuous or pulse manner in the presence of a gas of a fluorocompound represented by the formula CₓF_{y} and/or CₓFyO_{z} (wherein each of x, y and z is a positive integer not including 0) under such a condition that active species impinge on the substrate surface at a relatively lower collision energy than in step (a).

2. The process for producing a fluorocarbon film according to Claim 1, wherein as between steps (a) and (b), at least one condition among the average plasma output per unit time, the atmosphere pressure and the interelectrode distance, is changed.

3. The process for producing a fluorocarbon film according to Claim 1 or 2, wherein step (a) is carried out in the presence of at least one type of gas selected from the group consisting of hydrogen, helium, nitrogen, oxygen, fluorine, argon, carbon monoxide, carbon dioxide, steam and a gas of a fluorocompound represented by the formula CₓF_{y} and/or CₓF_{y}O_{z} (wherein each of x, y and z is a positive integer not including 0).

4. The process for producing a fluorocarbon film according to Claim 3, wherein in steps (a) and (b), the same gas is used.

5. A fluorocarbon film produced by the process for producing a fluorocarbon film according to any one of Claims 1 to 4.

6. A fluorocarbon film at least a part of which is chemically bonded to a substrate surface and which contains at most 8 mol% of CF group, from 20 to 90 mol% of CF₂ group and from 10 to 80 mol% of CF₃ group, based on the total amount of CF group, CF₂ group and CF₃ group.

7. The fluorocarbon film according to Claim 6, which has a film thickness of at most 10 µm.

8. A fluorocarbon film provided with a substrate, which comprises the fluorocarbon film as defined in Claim 6 or 7, formed on a substrate surface.
